(19) Europäisches Patentamt
European Patent Office
Office européen des brevets

(11) **EP 2 398 935 B1**

(12) **EUROPÄISCHE PATENTSCHRIFT**

(45) Veröffentlichungstag und Bekanntmachung des Hinweises auf die Patenterteilung:
**28.08.2019 Patentblatt 2019/35**

(21) Anmeldenummer: **10703450.6**

(22) Anmeldetag: **05.02.2010**

(51) Int Cl.:
***C23C 18/12*** *(2006.01)*

(86) Internationale Anmeldenummer:
**PCT/EP2010/051409**

(87) Internationale Veröffentlichungsnummer:
**WO 2010/094581 (26.08.2010 Gazette 2010/34)**

(54) **INDIUMALKOXID-HALTIGE ZUSAMMENSETZUNGEN, VERFAHREN ZU IHRER HERSTELLUNG UND IHRE VERWENDUNG**

COMPOSITION CONTAINING INDIUM ALKOXIDE, PROCESS FOR IT'S PREPARATION AND USE OF SUCH COMPOSITIONS

COMPOSITION COMPRENANT DE L'ALKOXYDE D'INDIUM, PROCÉDÉ DE PREPARATION ET UTILISATION DES COMPOSITIONS

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **17.02.2009 DE 102009009338**

(43) Veröffentlichungstag der Anmeldung:
**28.12.2011 Patentblatt 2011/52**

(73) Patentinhaber: **Evonik Degussa GmbH**
**45128 Essen (DE)**

(72) Erfinder:
• STEIGER, Jürgen
  40237 Düsseldorf (DE)
• THIEM, Heiko
  45721 Haltern am See (DE)
• MERKULOV, Alexey
  67059 Ludwigshafen (DE)
• PHAM, Duy Vu
  46049 Oberhausen (DE)
• DAMASCHEK, Yvonne
  45657 Recklinghausen (DE)
• HOPPE, Arne
  44623 Herne (DE)

(74) Vertreter: **Evonik Patent Association**
**c/o Evonik Industries AG**
**IP Management**
**Bau 1042A/PB 15**
**Paul-Baumann-Straße 1**
**45772 Marl (DE)**

(56) Entgegenhaltungen:
**WO-A1-2009/081968     JP-A- 2007 042 689**

**Beschreibung**

Die vorliegende Erfindung betrifft Indiumalkoxid-haltige Zusammensetzungen, Verfahren zu ihrer Herstellung und ihre Verwendung.

Die Herstellung halbleitender elektronischer Bauteilschichten über Druckprozesse ermöglicht im Vergleich zu vielen anderen Verfahren, wie z.B. Chemical Vapor Deposition (CVD), weitaus niedrigere Produktionskosten, da die Deposition des Halbleiters hier in einem kontinuierlichen Druckprozess erfolgen kann. Darüber hinaus eröffnet sich bei niedrigen Prozesstemperaturen die Möglichkeit, auf flexiblen Substraten zu arbeiten, und gegebenenfalls (vor allem im Falle sehr dünner Schichten und insbesondere bei oxidischen Halbleitern) eine optische Transparenz der gedruckten Schichten zu erreichen. Unter halbleitenden Schichten sind hier und im folgenden Schichten zu verstehen, die Ladungsträgerbeweglichkeiten von 0,1 bis 50 $cm^2$/Vs bei einem Bauteil mit einer Kanallänge von 20 $\mu$m und einer Kanalbreite von 1 cm bei 50 V Gate-Source-Spannung und 50 V Source-Drain-Spannung aufweisen.

Da das Material der über Druckverfahren herzustellenden Bauteilschicht die jeweiligen Schichteigenschaften maßgeblich bestimmt, hat seine Wahl einen bedeutsamen Einfluss auf jedes diese Bauteilschicht enthaltende Bauteil. Wichtige Parameter für gedruckte Halbleiterschichten sind ihre jeweiligen Ladungsträgerbeweglichkeiten sowie die Verarbeitbarkeiten und Verarbeitungstemperaturen der bei ihrer Herstellung eingesetzten verdruckbaren Vorstufen. Die Materialien sollten eine gute Ladungsträgerbeweglichkeit aufweisen und aus Lösung und bei Temperaturen deutlich unter 500 °C herstellbar sein, um für eine Vielzahl von Anwendungen und Substraten geeignet zu sein. Ebenfalls wünschenswert für viele neuartige Anwendungen ist eine optische Transparenz der erzeugten halbleitenden Schichten.

Indiumoxid (Indium(III)oxid, $In_2O_3$) ist aufgrund der großen Bandlücke zwischen 3.6 und 3.75 eV (gemessen für aufgedampfte Schichten) [H.S. Kim, P.D. Byrne, A. Facchetti, T.J. Marks; J. Am. Chem. Soc. 2008, 130, 12580-12581] ein vielversprechender Halbleiter. Dünne Filme von wenigen hundert Nanometern Dicke können darüber hinaus eine hohe Transparenz im sichtbaren Spektralbereich von größer als 90 % bei 550 nm aufweisen. In extrem hoch geordneten Indiumoxid-Einkristallen kann man zudem Ladungsträgerbeweglichkeiten von bis zu 160 $cm^2$/Vs messen. Bislang kön-nen jedoch solche Werte durch Prozessierung aus Lösung noch nicht erreicht werden [H. Nakazawa, Y. Ito, E. Matsumoto, K. Adachi, N. Aoki, Y. Ochiai; J. Appl. Phys. 2006, 100, 093706. und A. Gupta, H. Cao, Parekh, K.K.V. Rao, A.R. Raju, U.V. Waghmare; J. Appl. Phys. 2007, 101, 09N513].

Indiumoxid wird oft vor allem zusammen mit Zinn(IV)-oxid ($SnO_2$) als halbleitendes Mischoxid ITO eingesetzt. Aufgrund der verhältnismäßig hohen Leitfähigkeit von ITO-Schichten bei gleichzeitiger Transparenz im sichtbaren Spektralbereich findet es unter anderem Anwendung im Bereich von Flüssigkristallbildschirmen (LCD; liquid crystal display), insbesondere als "durchsichtige Elektrode". Diese zumeist dotierten Metalloxid-Schichten werden industriell vor allem durch kostenintensive Aufdampfmethoden im Hochvakuum hergestellt. Aufgrund des großen wirtschaftlichen Interesses an ITO-beschichteten Substraten existieren mittlerweile einige, vor allem auf Sol-Gel-Techniken beruhende Beschichtungsverfahren für Indiumoxid-haltige Schichten.

Prinzipiell gibt es zwei Möglichkeiten für die Herstellung von Indiumoxid-Halbleitern über Druckverfahren: 1) Partikel-Konzepte, bei denen (Nano)Partikel in verdruckbarer Dispersion vorliegen und nach dem Druckvorgang durch Sintervorgänge in die gewünschte Halbleiterschicht konvertiert werden, sowie 2) Precursor-Konzepte, bei denen mindestens ein lösliches Vorprodukt nach dem Verdrucken zu einer Indiumoxid-haltigen Schicht umgesetzt wird. Das Partikelkonzept hat zwei bedeutende Nachteile gegenüber dem Einsatz von Precursoren: Zum einen weisen die Partikel-Dispersionen eine kolloidale Instabilität auf, die die Anwendung von (in Bezug auf die späteren Schichteigenschaften nachteiligen) Dispergieradditiven erforderlich macht, zum anderen bilden viele der einsetzbaren Partikel (z.B. aufgrund von Passivierungsschichten) nur unvollständig Schichten durch Sinterung aus, so dass in den Schichten teilweise noch partikuläre Strukturen vorkommen. An deren Partikelgrenze kommt es zu einem erheblichen Partikel-Partikel-Widerstand, welcher die Beweglichkeit der Ladungsträger verringert und den allgemeinen Schichtwiderstand erhöht.

Es gibt verschiedene Precursoren für die Herstellung von Indiumoxid-haltigen Schichten. So können neben Indiumsalzen z.B. auch Indiumalkoxide als Precursoren für die Herstellung von Indiumoxid-haltigen Schichten eingesetzt werden.

Zum Beispiel beschreiben Marks et al. Bauteile, bei deren Herstellung eine Precursorlösung aus $InCl_3$ sowie der Base Monoethanolamin (MEA) gelöst in Methoxyethanol eingesetzt wird. Nach Aufschleudern (Spin-coating) der Lösung wird die entsprechende Indiumoxid-Schicht durch eine thermische Behandlung bei 400 °C erzeugt. [H.S. Kim, P.D. Byrne, A. Facchetti, T.J. Marks; J. Am. Chem. Soc. 2008, 130, 12580-12581 and supplemental informations]

Gegenüber Indiumsalz-Lösungen bieten Indiumalkoxid-Lösungen den Vorteil, dass sie bei geringeren Temperaturen zu Indiumoxid-haltigen Beschichtungen umgewandelt werden können.

Indiumalkoxide und ihre Synthese sind bereits seit den siebziger Jahren des vorigen Jahrhunderts beschrieben. Mehrotra et al. beschreiben die Herstellung von Indium-tris-Alkoxid $In(OR)_3$ aus Indium(III)chlorid ($InCl_3$) mit Na-OR, wobei R für-Methyl, -Ethyl, iso-Propyl, n-, s-, t-Butyl und -Pentyl Reste steht. [S. Chatterjee, S. R. Bindal, R.C. Mehrotra; J. Indian Chem. Soc.1976, 53, 867].

Bradley et al. berichten von einer ähnlichen Reaktion wie Mehrotra et al. und erhalten bei annähernd identischen

Edukten (InCl$_3$, Isopropyl-Natrium) und Reaktionsbedingungen einen Indium-Oxo-Cluster mit Sauerstoff als Zentralatom [D.C. Bradley, H. Chudzynska, D.M. Frigo, M.E. Hammond, M.B. Hursthouse, M.A. Mazid; Polyhedron 1990, 9, 719].

Hoffman et al. zeigen eine alternative Syntheseroute zu Indium-Isopropoxid und erhalten im Gegensatz zu Mehrotra et al. einen unlöslichen weißen Feststoff. Sie vermuten einen polymeren Stoff [In(O-iPr)$_3$]$_n$ [S. Suh, D. M. Hoffman; J. Am. Chem. Soc. 2000, 122, 9396-9404].

Viele Verfahren zur Herstellung von Indiumoxid-haltigen Beschichtungen über Precursorverfahren beruhen auf Sol-Gel-Techniken, bei denen aus Precursoren herstellbare Metallat-Gele durch einen Konvertierungsschritt in die entsprechenden Oxid-Schichten umgewandelt werden.

So beschreibt JP 11-106934 A (Fuji Photo Film Co. Ltd.) ein Verfahren zur Herstellung eines transparenten leitfähigen Metall-Oxid-Filmes auf einem transparenten Substrat über einen Sol-Gel-Prozess, bei dem unterhalb von 0 °C ein Metallalkoxid oder ein Metallsalz, bevorzugt ein Indiumalkoxid oder Indiumsalz, in Lösung hydrolysiert wird und dann das Hydrolysat erhitzt wird.

JP 06-136162 A (Fujimori Kogyo K.K.) beschreibt ein Verfahren zur Herstellung eines Metalloxid-Filmes aus Lösung auf einem Substrat, bei dem eine Metall-Alkoxid-Lösung, insbesondere eine Indium-Isopropoxid-Lösung, zu einem Metall-Oxid-Gel umgesetzt, auf ein Substrat aufgetragen, getrocknet und mit Wärme behandelt wird, wobei vor, während oder nach dem Trocknungs- und Wärmebehandlungsschritt mit UV-Strahlung bestrahlt wird.

Auch JP 09-157855 A (Kansai Shin Gijutsu Kenkyusho K.K.) beschreibt die Herstellung von Metalloxid-Filmen aus Metall-Alkoxid-Lösungen über eine Metall-Oxid-Sol-Zwischenstufe, die auf das Substrat aufgebracht und durch UV Strahlung in das jeweilige Metalloxid umgewandelt werden. Bei dem resultierenden Metalloxid kann es sich um Indiumoxid handeln.

CN 1280960 A beschreibt die Herstellung einer Indium-Zinn-Oxid-Schicht aus Lösung über ein Sol-Gel-Verfahren, bei dem ein Gemisch von Metall-Alkoxiden in einem Lösemittel gelöst, hydrolysiert und dann zur Beschichtung eines Substrates mit nachfolgender Trocknung und Härtung eingesetzt wird.

Diese Sol-Gel-Verfahren haben jedoch gemein, dass ihre Gele entweder aufgrund der hohen Viskosität nicht für den Einsatz bei Druckprozessen geeignet sind und/oder, insbesondere im Falle gering konzentrierter Lösungen, die resultierenden Indiumoxid-haltigen Schichten Inhomogenitäten und somit schlechte Schicht-Parameter aufweisen. Unter einer Inhomogenität wird im vorliegenden Fall eine Kristallbildung in einzelnen Domänen verstanden, die an der Oberfläche zu Rauhigkeiten von über Rms = 20 nm (quadratische Rauheit, englisch *rms-roughness* = *root-mean-squared roughness*: Wurzel des Mittelquadrates; gemessen über Atomic Force Microscopy) führt. Diese Rauhigkeit wirkt sich zum einen nachteilig auf die Schichteigenschaften der Indiumoxid-haltigen Schicht (es resultieren vor allem zu geringe Ladungsträgerbeweglichkeiten für Halbleiter-Anwendungen) und zum anderen nachteilig für das Aufbringen weiterer Schichten zur Erzeugung eines Bauteils aus.

Im Gegensatz zu den bisher beschriebenen Sol-Gel-Techniken wird in JP 11-106935 A (Fuji Photo Film Co. Ltd.) ein Verfahren zur Herstellung eines leitfähigen Metall-Oxid-Filmes auf einem transparenten Substrat beschrieben, bei dem zur Erzielung von Härtungstemperaturen unterhalb von 250 °C, bevorzugt unterhalb von 100 °C, eine Beschichtungszusammensetzung enthaltend ein Metall-Alkoxid und/oder ein Metallsalz auf einem transparenten Substrat thermisch getrocknet und anschließend mit UV- oder VIS-Strahlung konvertiert wird.

Die bei diesem Verfahren eingesetzte Konvertierung über elektromagnetische Strahlung hat jedoch den Nachteil, dass die resultierende Halbleiterschicht an der Oberfläche wellig und uneben ist. Dieses resultiert aus der Schwierigkeit, eine gleichmäßige und gleichförmige Strahlungsverteilung auf dem Substrat zu erreichen.

JP 2007-042689 A beschreibt Metallalkoxid-Lösungen, die zwingend Zinkalkoxide enthalten und weiterhin Indiumalkoxide enthalten können, sowie Verfahren zur Herstellung von Halbleiterbauelementen, die diese Metallalkoxid-Lösungen einsetzen. Die Metallalkoxid-Filme werden thermisch behandelt und zur Oxid-Schicht umgewandelt.

Auch diese Systeme liefern jedoch nicht ausreichend homogene Filme.

Der vorliegenden Erfindung liegt somit die Aufgabe zugrunde, gegenüber dem bekannten Stand der Technik Systeme bereitzustellen, mit denen Indiumoxid-haltige Schichten ohne die erwähnten Nachteile des dargelegten Standes der Technik hergestellt werden können, d.h. Systeme bereitzustellen, die in herkömmlichen Druckverfahren einsetzbar sind und mit denen Indiumoxid-haltige Schichten einer besseren Qualität hergestellt werden können, die eine hohe Homogenität und eine geringe Welligkeit, Unebenheit und Rauhigkeit (insbesondere eine Rauhigkeit ≤ 20 nm Rms) aufweisen.

Diese Aufgabe wird gelöst durch flüssige Indiumalkoxid-haltige Zusammensetzungen, umfassend mindestens ein Indiumalkoxid und mindestens drei Lösemittel L$_1$, L$_2$ und L$_3$, dadurch gekennzeichnet, dass das Lösemittel L$_1$ ausgewählt wird aus der Gruppe bestehend aus Ethyllactat, Anisol, Tetrahydrofurfurylalkohol, Butylacetat, Ethylenglycoldiacetat und Ethylbenzoat, und die Differenz der Siedepunkte der beiden Lösemittel L$_2$ und L$_3$ unter SATP-Bedingungen mindestens 30 °C beträgt wobei die Lösemittel L2 und L3 organische Lösemittel sind, die unabhängig voneinander ausgewählt aus der Gruppe bestehend aus -Alkoholen, Polyalkoholen, Estern, Aminen, Ketonen oder Aldehyden sind und wobei gewährleistet ist, dass immer mindestens drei unterschiedliche Lösemittel vorliegen.

Überraschenderweise konnte dabei festgestellt werden, dass sich in Zusammensetzungen mit mehr als zwei Lösungsmitteln ohne eine signifikante Verschlechterung der Qualität der mit der Zusammensetzung erzeugbaren Indiumoxid-haltigen Schichten die Lagerungsbeständigkeit und die Haltbarkeit der erfindungsgemäßen Zusammensetzungen an Luft gegenüber Systemen mit nur zwei Lösemitteln signifikant verbesserte. Dieser Effekt war besonders ausgeprägt, wenn das System mindestens eines der folgendes Lösungsmittel enthielt: Ethyllactat, Anisol, Tetrahydrofurfurylalkohol oder Butylacetat.

Unter flüssigen Zusammensetzungen im Sinne der vorliegenden Erfindung sind dabei solche zu verstehen, die bei SATP-Bedingungen ("Standard Ambient Temperature and Pressure"; T = 25 °C und p = 1013 hPa) flüssig vorliegen.

Das Indiumalkoxid ist bevorzugt ein Indium(III)alkoxid. Weiter bevorzugt handelt es sich bei dem Indium(III)-alkoxid um ein Alkoxid mit mindestens einer C1- bis C15-Alkoxy- oder -Oxyalkylalkoxygruppe, besonders bevorzugt mindestens einer C1- bis C10-Alkoxy- oder -Oxyalkylalkoxygruppe. Ganz besonders bevorzugt ist das Indium(III)-Alkoxid ein Alkoxid der generischen Formel $In(OR)_3$, in der R eine C1- bis C15-Alkyl- oder -Alkyloxyalkylgruppe, noch weiter bevorzugt eine C1- bis C10-Alkyl- oder -Alkyloxyalkylgruppe darstellt. Besonders bevorzugt ist dieses Indium(III)-Alkoxid $In(OCH_3)_3$, $In(OCH_2CH_3)_3$, $In(OCH_2CH_2OCH_3)_3$, $In(OCH(CH_3)_2)_3$ oder $In(O(CH_3)_3)_3$. Noch weiter bevorzugt wird $In(OCH(CH_3)_2)_3$ (Indiumisopropoxid) eingesetzt.

Das Indiumalkoxid liegt in der Zusammensetzung bevorzugt in Anteilen von 1 bis 15 Gew.-%, besonders bevorzugt 2 bis 10 Gew.-%, ganz besonders bevorzugt 2,5 bis 7,5 Gew.-% bezogen auf die Gesamtmasse der Zusammensetzung vor.

Bevorzugte Zusammensetzungen sind solche, bei denen der Siedepunkt von $L_2$ unter SATP-Bedingungen 30-120 °C und der Siedepunkt von $L_3$ unter SATP-Bedingungen 120-300 °C beträgt, wiederum mit der Maßgabe, dass die beiden ausgewählten Lösemittel eine Siedepunktsdifferenz von mindestens 30 °C unter SATP-Bedingungen aufweisen.

Ganz besonders bevorzugt ist das Lösemittel $L_2$ in der Zusammensetzung ausgewählt aus der Gruppe bestehend aus Isopropanol, Methanol, Ethanol, Aceton, Toluol, Tetrahydrofuran, Methylethylketon, Chloroform, Ethylacetat, Ethylenglycoldimethylether.

Weiterhin ganz besonders bevorzugt ist das $L_3$ ausgewählt aus der Gruppe bestehend aus Tetrahydrofurfurylalkohol, Butylacetat, Anisol, Ethylbenzoat, Ethylenglycoldiacetat, Ethyllactat und Diethylenglycol, noch weiter bevorzugt Diethylenglycol, Butylacetat und Ethyllactat.

Ganz besonders hochwertige Indiumoxid-haltige Schichten können mit Zusammensetzungen umfassend $L_2$ = Isopropanol und $L_3$ = Diethylenglycol hergestellt werden.

Bevorzugt enthalten die erfindungsgemäßen Zusammensetzungen das Lösemittel $L_2$ in Anteilen von 30 - 95 Gew.-%, bezogen auf die Gesamtmasse der Zusammensetzung, und dass Lösemittel $L_3$ in Anteilen von 0,5 - 70 Gew.-% bezogen auf die Gesamtmasse der Zusammensetzung.

Ganz besonders lagerungsbeständige und stabile Zusammensetzungen wurden mit einem Gemisch aus den Lösemitteln Isopropanol, Butylacetat und Ethyllactat erreicht.

Mit den erfindungsgemäßen Zusammensetzungen können - in dem Fall, dass die Zusammensetzung neben dem Indiumalkoxid keine weiteren Metallprecursoren enthält - qualitativ sehr hochwertige Indiumoxid-Schichten hergestellt werden. Unter einer Indiumoxid-Schicht im Sinne der vorliegenden Erfindung ist dabei eine aus den erwähnten Indiumalkoxiden herstellbare, metallhaltige Schicht zu verstehen, die im Wesentlichen Indiumatome bzw. -ionen aufweist, wobei die Indiumatome bzw. -ionen im Wesentlichen oxidisch vorliegen. Gegebenenfalls kann die Indiumoxid-Schicht auch noch Carben- bzw. Alkoxid-Anteile aus einer nicht vollständigen Konvertierung aufweisen. Im Gegensatz dazu ist unter einer Indiumoxid-haltigen Schicht eine Schicht zu verstehen, die neben den im Wesentlichen oxidisch vorliegenden Indiumatomen bzw. -ionen auch noch weitere Metalle, Halbmetalle oder ihre entsprechenden Oxide aufweist.

Vorteilhaft weist die erfindungsgemäße Zusammensetzung jedoch noch mindestens einen weiteren (Halb)Metallprecursor auf. Besonders qualitativ hochwertige Indiumoxid-haltige Schichten können dabei hergestellt werden, wenn die Zusammensetzung noch mindestens ein weiteres (Halb)Metallalkoxid aufweist. Der Begriff (Halb)Metallalkoxid umfasst dabei sowohl Halbmetallalkoxide als auch Metallalkoxide.

Dieses mindestens eine (Halb)Metallalkoxid liegt bevorzugt in Anteilen von 0,01 - 7,5 Gew.-%, bezogen auf die Gesamtmasse der Zusammensetzung vor.

Bevorzugt ist das mindestens eine (Halb)Metallalkoxid ein Alkoxid eines Metalls oder Halbmetalls ausgewählt aus der Gruppe bestehend aus den Metallen bzw. Halbmetallen der Gruppe 1, 2, 3, 4, 5, 6, 7, 8, 9, 10, 11, 12, 13, 14 oder 15, bevorzugt ein Alkoxid eines Metalls bzw. Halbmetalls ausgewählt aus der Gruppe bestehend aus Zn, Ga, Sn, Mg, Fe, Al, Ba, Cu, Ti, Si, Pb, Zr, Hf, Ta, Nb, Ge, Mn, Re, Ru und Ag. Ganz besonders bevorzugt ist das (Halb)Metallalkoxid ein Alkoxid eines Metalls bzw. Halbmetalls ausgewählt aus der Gruppe bestehend aus Zn, Ga, Sn, Ti und Cu.

Das mindestens eine weitere (Halb)Metallalkoxid ist bevorzugt ein Alkoxid mit mindestens einer C1- bis C15-Alkoxy- oder -Oxyalkylalkoxygruppe, besonders bevorzugt mindestens einer C1- bis C10-Alkoxy- oder -Oxyalkylalkoxygruppe. Ganz besonders bevorzugt ist das (Halb)Metallalkoxid ein Alkoxid der generischen Formel $In(OR)_3$, in der R eine C1- bis C15-Alkyl- oder -Alkyloxyalkylgruppe, noch weiter bevorzugt eine C1- bis C10-Alkyl- oder -Alkyloxyalkylgruppe darstellt. Besonders bevorzugt ist dieses (Halb)Metallalkoxid ein Alkoxid des Typs $M^{(x)}(OCH_3)_x$, $M^{(x)}(OCH_2CH_3)_x$, $M^{(x)}(OCH_2CH_2OCH_3)_x$, $M^{(x)}(OCH(CH_3)_2)_x$ oder $M^{(x)}(O(CH_3)_3)_x$ wobei der Index x der entsprechenden Wertigkeit des (Halb)Metalls entspricht.

Die erfindungsgemäßen Zusammensetzungen können dadurch hergestellt werden, dass das mindestens eine Indiumalkoxid mit einem Gemisch umfassend die mindestens drei Lösemittel vermischt wird.

Alternativ können die erfindungsgemäßen Zusammensetzungen auch dadurch hergestellt werden, dass eine Zusammensetzung umfassend das mindestens eine Indiumalkoxid und mindestens ein Lösemittel mit dem bzw. den anderen Lösemittel(n) vermischt wird.

Gegenstand der vorliegenden Erfindung ist weiterhin die Verwendung der erfindungsgemäßen Zusammensetzungen zur Herstellung halbleitender Strukturen.

Die mit den erfindungsgemäßen Zusammensetzungen herstellbaren halbleitenden Indiumoxid-haltigen Strukturen weisen Ladungsträgerbeweglichkeiten zwischen 0,1 und 50 cm$^2$/Vs (gemessen bei 50 V Gate-Source-Spannung, 50 V Drain-Source-Spannung, 1 cm Kanalbreite und 20 $\mu$m Kanallänge) auf, wobei diese über das Modell der "Gradual Channel Approximation" bestimmt werden können. Hierzu werden die von klassischen MOSFETs bekannten Formeln verwendet. Im linearen Bereich gilt:

$$I_D = \frac{W}{L} C_i \mu \left( U_{GS} - U_T - \frac{U_{DS}}{2} \right) U_{DS} \tag{1}$$

wobei $I_D$ der Drain-Strom, $U_{DS}$ die Drain-Source-Spannung, $U_{GS}$ die Gate-Source-Spannung, $C_i$ die flächennormierte Kapazität des Isolators, $W$ die Breite des Transistorkanals, $L$ die Kanallänge des Transistors, $\mu$ die Ladungsträgerbeweglichkeit und $U_T$ die Schwellenspannung sind.

Im Sättigungsbereich gilt eine quadratische Abhängigkeit zwischen Drain-Strom und Gate-Spannung, die vorliegend zur Bestimmung der Ladungsträgerbeweglichkeit verwendet wird:

$$I_D = \frac{W}{2L} C_i \mu (U_{GS} - U_T)^2 \tag{2}$$

Bevorzugt werden die erfindungsgemäßen Zusammensetzungen bei Verfahren zur Herstellung halbleitender Indiumoxid-haltiger Strukturen, insbesondere halbleitender Indiumoxid-haltiger Schichten verwendet. Gegenstand der vorliegenden Erfindung ist somit auch die Verwendung der erfindungsgemäßen Zusammensetzungen zur Herstellung halbleitender Strukturen. Bevorzugt erfolgt diese Verwendung in Form des Einsatzes der erfindungsgemäßen Zusammensetzungen bei Beschichtungsverfahren, mit denen halbleitende Strukturen hergestellt werden. Besonders gut geeignet sind die erfindungsgemäßen Zusammensetzungen für den Einsatz bei Beschichtungsverfahren ausgewählt aus Druckverfahren (insbesondere Flexo/Gravur-Druck, Inkjet-Druck, Offset-Druck, digitalem Offset-Druck und Siebdruck), Sprühverfahren, Rotationsbeschichtungsverfahren ("Spin-coating") und Tauchverfahren ("Dip-coating"). Ganz besonders bevorzugt ist das erfindungsgemäße Druckverfahren ein Druckverfahren.

Das Substrat, das bei diesen erfindungsgemäßen Verfahren eingesetzt wird, ist bevorzugt ein Substrat ausgewählt aus Substraten bestehend aus Glas, Silicium, Siliciumdioxid, einem Metall- oder Übergangsmetalloxid oder einem polymeren Material, insbesondere PE, PEN, PI oder PET.

Nach der Beschichtung und vor der Konvertierung kann das beschichtete Substrat weiterhin getrocknet werden. Entsprechende Maßnahmen und Bedingungen hierfür sind dem Fachmann bekannt.

Die Konvertierung der erzeugten Struktur bzw. Schicht zu Indiumoxid bzw. einer Indiumoxid-haltigen Schicht bzw. Struktur kann auf thermischem Wege und/oder durch UV-, IR- oder VIS-Strahlung erfolgen. Besonders gute Ergebnisse können jedoch erzielt werden, wenn zur Konvertierung Temperaturen von 150 °C bis 360 °C eingesetzt werden.

Dabei werden typischerweise Konvertierungszeiten von einigen Sekunden bis hin zu mehreren Stunden verwendet.

Die Konvertierung kann weiterhin dadurch unterstützt werden, dass die nach dem Beschichtungsschritt erhaltene Schicht vor der thermischen Behandlung in Kontakt mit Wasser und/oder Wasserstoffperoxid gebracht wird und diese in einem Zwischenschritt zunächst zu einem Metallhydroxid umzuwandeln, bevor die thermische Umwandlung erfolgt.

Die Güte der nach dem erfindungsgemäßen Verfahren erzeugten Schicht kann weiterhin durch eine an den Konvertierungsschritt anschließende kombinierte Temperatur- und Gasbehandlung (mit $H_2$ oder $O_2$), Plasmabehandlung (Ar-, $N_2$, $O_2$ oder $H_2$-Plasma), Mikrowellenbehandlung, Laser-Behandlung (mit Wellenlängen im UV-, VIS- oder IR-Bereich), UV-Licht, Infrarotstrahlung oder eine Ozon-Behandlung weiter verbessert werden.

Gegenstand der Erfindung sind weiterhin mit den erfindungsgemäßen Zusammensetzungen herstellbare Indiumoxid-haltigen Schichten.

Die mit den erfindungsgemäßen Zusammensetzungen herstellbaren Indiumoxid-haltigen Strukturen eignen sich weiterhin vorteilhaft für die Herstellung elektronischer Bauteile, insbesondere die Herstellung von (Dünnschicht)Transistoren, Dioden oder Solarzellen.

Die nachfolgenden Beispiele sollen den Gegenstand der vorliegenden Erfindung näher erläutern.

**Vergleichsbeispiel :**

Ansetzen der Lösung 0

Zu einer 5 Gew.-% Lösung von Indium(III)-Isopropoxid in Isopropanol (bp: 82 °C) wurden 10 Vol.-% Isopropanol hinzugefügt. Auf diese Weise lassen sich Effekte, die durch die veränderte Konzentration im erfindungsgemäßen Beispiel entstehen, ausschließen.

Beschichtung

Ein dotiertes Siliciumsubstrat mit einer Kantenlänge von etwa 15 mm und mit einer ca. 200 nm dicken Siliciumoxid-Beschichtung und Fingerstrukturen aus ITO/Gold wurde unter den gleichen Bedingungen wie zuvor ausgeführt mit 100 $\mu$L der angesetzten Lösung 0 per Spin-Coating (2000 rpm) an Luft unter SATP-Bedingungen beschichtet. Nach dem Beschichtungsvorgang wurde das beschichtete Substrat an der Luft bei einer Temperatur von 350 °C eine Stunde lang getempert.

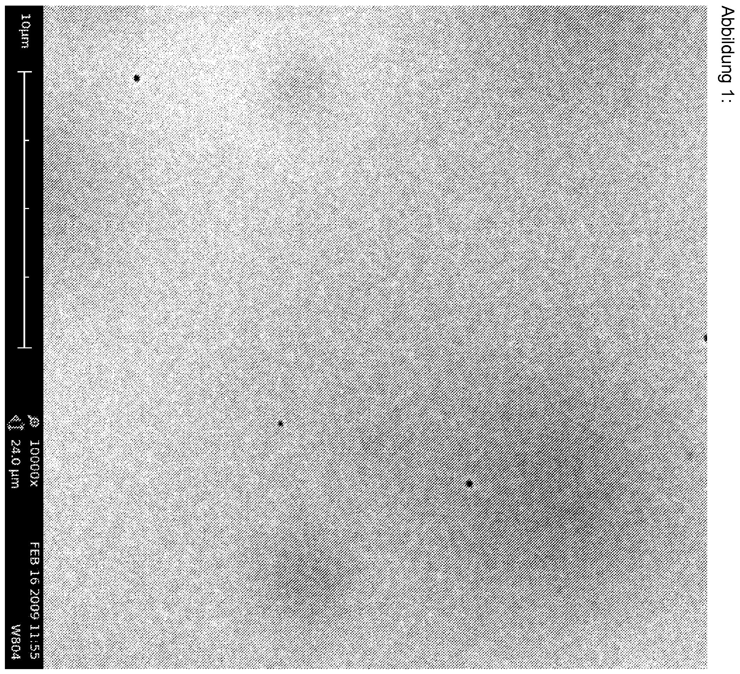

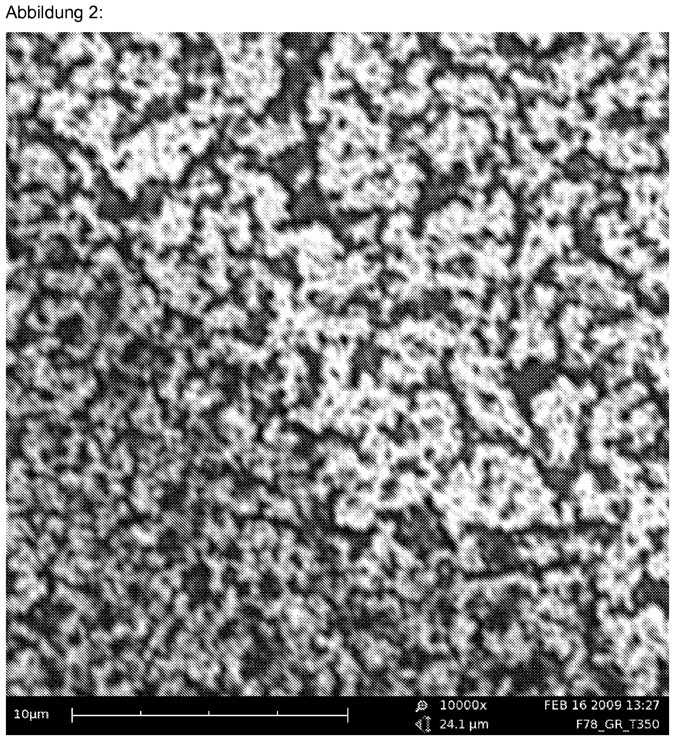

Abbildung 1 zeigt eine SEM-Aufnahme der resultierenden $In_2O_3$-Schicht der erfindungsgemäßen Beschichtung, Abbildung 2 eine entsprechende SEM-Aufnahme des Vergleichsbeispiels (Vergrößerung: 10.000x). Deutlich zu erkennen ist die wesentlich geringere Rauhigkeit der erfindungsgemäßen Schicht. Weiterhin sind die Schichten des Vergleichsbeispiels wesentlich inhomogener als die des erfindungsgemäßen Beispiels.

Die erfindungsgemäße Beschichtung zeigt eine Ladungsträgerbeweglichkeit von 1 cm$^2$/Vs (bei 50 V Gate-Source-Spannung, 50 V Source-Drain-Spannung, 1 cm Kanalbreite und 20 $\mu$m Kanallänge). Demgegenüber beträgt die Ladungsträgerbeweglichkeit in der Schicht des Vergleichsbeispiels nur 0,02 cm$^2$/Vs (bei 50 V Gate-Source-Spannung, 50 V Source-Drain-Spannung, 1 cm Kanalbreite und 20 $\mu$m Kanallänge).

**Erfindungsgemäße Beispiele 1 - 4**

Analog zu dem oben genannten Beispiel wurden weitere Zusammensetzungen hergestellt. Mit diesen Lösungen wurden analog zum Vergleichsbeispiel Transistoren gebaut und deren Ladungsträgerbeweglichkeiten vermessen. Tabelle 1 enthält die Zusammenfassung der hergestellten Lösungen und die gemessenen Beweglichkeiten.

Ansetzen der Lösung 1

Zu einer 5 Gew.-% Lösung von Indium(III)-Isopropoxid in Isopropanol (bp: 82 °C) wurden 10 Vol.-% eines Gemisches aus 50 Vol.-% Butylacetat (bp: 127 °C) und 50 Vol.-% Ethyllactat (bp: 154 °C) hinzugefügt.

Ansetzen der Lösung 2

Zu einer 5 Gew.-% Lösung von Indium(III)-Isopropoxid in Isopropanol (bp: 82 °C) wurden 10 Vol.-% eines Gemisches aus 50 Vol.-% Diethylenglycol (bp: 244 °C) und 50 Vol.-% Anisol (bp: 155 °C) hinzugefügt.

Ansetzen der Lösung 3

Zu einer 5 Gew.-% Lösung von Indium(III)-Isopropoxid in Isopropanol (bp: 82 °C) wurden 10 Vol.-% eines Gemisches aus 50 Vol.-% Diethylenglycol (bp: 244 °C) und 50 Vol.-% Ethylenglycoldiacetat (bp: 190 °C) hinzugefügt.

Ansetzen der Lösung 4

Zu einer 5 Gew.-% Lösung von Indium(III)-Isopropoxid in Isopropanol (bp: 82 °C) wurden 10 Vol.-% eines Gemisches aus 50 Vol.-% Diethylenglycol (bp: 244 °C) und 50 Vol.-% Ethylbenzoat (bp: 214 °C) hinzugefügt.

Beschichtung

Ein dotiertes Siliciumsubstrat mit einer Kantenlänge von etwa 15 mm und mit einer ca. 200 nm dicken Siliciumoxid-Beschichtung und Fingerstrukturen aus ITO/Gold wurde unter den gleichen Bedingungen wie zuvor ausgeführt mit 100 μL der jeweiligen Lösung per Spin-Coating (2000 rpm) an Luft unter SATP-Bedingungen beschichtet. Nach dem Beschichtungsvorgang wurde das beschichtete Substrat an der Luft bei einer Temperatur von 350 °C eine Stunde lang getempert. Die Ergebnisse der elektrischen Messungen können Tabelle 1 entnommen werden.

**Tabelle 1:**

| Beispiel Nr. | Lösungsmittel 1 | bpLM 1 | Lösungsmittel 2 | bpLM 2 | Lösungsmittel 3 | bpLM 3 | μ |
|---|---|---|---|---|---|---|---|
| 0 | Isopropanol | 82 °C | - | - | - | - | 0,02 cm$^2$/Vs |
| 1 | Isopropanol | 82 °C | Butylacetat | 127 °C | Ethyllactat | 154 °C | 0,4 cm$^2$/Vs |
| 2 | Isopropanol | 82 °C | Diethylenglycol | 244 °C | Anisol | 155 °C | 0,6 cm$^2$/Vs |
| 3 | Isopropanol | 82 °C | Diethylenglycol | 244 °C | Ethylenglycoldiacetat | 190 °C | 0,8 cm$^2$/Vs |
| 4 | Isopropanol | 82 °C | Diethylenglycol | 244 °C | Ethylbenzoat | 214 °C | 0,9 cm$^2$/Vs |

**Patentansprüche**

1. Flüssige Indiumalkoxid-haltige Zusammensetzung, umfassend

   - mindestens ein Indiumalkoxid und
   - mindestens drei Lösemittel $L_1$, $L_2$ und $L_3$,

   **dadurch gekennzeichnet, dass** das Lösemittel $L_1$ ausgewählt ist aus der Gruppe bestehend aus Ethyllactat, Anisol, Tetrahydrofurfurylalkohol, Butylacetat, Ethylenglycoldiacetat und Ethylbenzoat, und die Differenz der Siedepunkte der beiden Lösemittel $L_2$ und $L_3$ unter SATP-Bedingungen mindestens 30 °C beträgt, wobei die Lösemittel $L_2$ und $L_3$ organische Lösemittel sind, die unabhängig voneinander ausgewählt aus der Gruppe bestehend aus Alkoholen, Polyalkoholen, Estern, Aminen, Ketonen oder Aldehyden sind und wobei gewährleistet ist, dass immer mindestens drei unterschiedliche Lösemittel vorliegen.

2. Zusammensetzung nach Anspruch 1, **dadurch gekennzeichnet, dass** Lösemittel $L_1$ ausgewählt ist aus der Gruppe bestehend aus Ethyllactat, Anisol, Tetrahydrofurfurylalkohol und Butylacetat.

3. Zusammensetzung nach Anspruch 1 oder 2, **dadurch gekennzeichnet, dass** das mindestens eine Indiumalkoxid ein Indium(III)alkoxid mit mindestens einer C1- bis C15-Alkoxy- oder -Oxyalkylalkoxygruppe ist.

4. Zusammensetzung nach Anspruch 3, **dadurch gekennzeichnet, dass** das Indium(III)alkoxid Indiumisopropoxid ist.

5. Zusammensetzung nach einem der vorhergehenden Ansprüche, **dadurch gekennzeichnet, dass** das Indiumalkoxid in der Zusammensetzung in Anteilen von 1 bis 15 Gew.-%, besonders bevorzugt 2 bis 10 Gew.-%, ganz besonders bevorzugt 2,5 bis 7,5 Gew.-% bezogen auf die Gesamtmasse der Zusammensetzung vorliegt.

6. Zusammensetzung nach einem der vorhergehenden Ansprüche, **dadurch gekennzeichnet, dass** der Siedepunkt von $L_2$ unter SATP-Bedingungen 30 - 120 °C und der Siedepunkt von $L_3$ unter SATP-Bedingungen 120 - 300 °C beträgt.

7. Zusammensetzung nach einem der vorhergehenden Ansprüche, **dadurch gekennzeichnet, dass** $L_2$ ausgewählt ist aus der Gruppe bestehend aus Isopropanol, Methanol, Ethanol, Aceton, Toluol, Tetrahydrofuran, Ethylacetat, Methylethylketon, Chloroform und Ethylenglycoldimethylether.

8. Zusammensetzung nach einem der vorhergehenden Ansprüche, **dadurch gekennzeichnet, dass** $L_3$ ausgewählt ist aus der Gruppe bestehend aus Tetrahydrofurfurylalkohol, Butylacetat, Diethylenglycol, Anisol, Ethylenglycoldiacetat, Ethylbenzoat und Ethyllactat.

9. Zusammensetzung nach einem der vorhergehenden Ansprüche, **dadurch gekennzeichnet, dass** die Zusammensetzung die zwei Lösemittel Isopropanol und Diethylenglycol umfasst.

10. Zusammensetzung nach einem der vorhergehenden Ansprüche, **dadurch gekennzeichnet, dass** der Anteil von $L_2$ 30 - 95 Gew.-%, bezogen auf die Gesamtmasse der Zusammensetzung, und der Anteil von $L_3$ 0,5 - 70 Gew.-%, bezogen auf die Gesamtmasse der Zusammensetzung beträgt.

11. Zusammensetzung nach einem der vorhergehenden Ansprüche, **dadurch gekennzeichnet, dass** die Zusammensetzung mindestens die drei Lösemittel Isopropanol, Butylacetat und Ethyllactat aufweist.

12. Zusammensetzung nach einem der vorhergehenden Ansprüche, **dadurch gekennzeichnet, dass** sie noch mindestens ein weiteres Metallalkoxid aufweist.

13. Zusammensetzung nach Anspruch 12, **dadurch gekennzeichnet, dass** der Anteil des mindestens einen Metallalkoxids 0,01 - 7,5 Gew.-%, bezogen auf die Gesamtmasse der Zusammensetzung, beträgt.

14. Verfahren zur Herstellung einer flüssigen Indiumalkoxid-haltigen Zusammensetzung nach einem der vorhergehenden Ansprüche, **dadurch gekennzeichnet, dass** das mindestens eine Indiumalkoxid mit einem Gemisch der mindestens drei Lösemittel vermischt wird.

15. Verfahren zur Herstellung einer flüssigen Indiumalkoxid-haltigen Zusammensetzung nach einem der Ansprüche 1 bis 13, **dadurch gekennzeichnet, dass** eine Zusammensetzung umfassend das mindestens eine Indiumalkoxid und mindestens ein Lösemittel mit dem bzw. den anderen Lösemitteln vermischt wird.

16. Verwendung einer Zusammensetzung nach einem der Ansprüche 1 bis 13 zur Herstellung halbleitender Strukturen.

17. Verwendung einer Zusammensetzung nach einem der Ansprüche 1 bis 13 zur Herstellung elektronischer Bauteile, insbesondere zur Herstellung von (Dünnschicht)Transistoren, Dioden oder Solarzellen.

**Claims**

1. Liquid indium alkoxide-containing composition comprising

    - at least one indium alkoxide and
    - at least three solvents $L_1$, $L_2$ and $L_3$,

    **characterized in that** the solvent $L_1$ is selected from the group consisting of ethyl lactate, anisole, tetrahydrofurfuryl alcohol, butyl acetate, ethylene glycol diacetate and ethyl benzoate, and the difference between the boiling points of the two solvents $L_2$ and $L_3$ under SATP conditions is at least 30°C, the solvents $L_2$ and $L_3$ being organic solvents which are each independently selected from the group consisting of alcohols, polyalcohols, esters, amines, ketones and aldehydes, and it being ensured that at least three different solvents are always present.

2. Composition according to Claim 1, **characterized in that** solvent $L_1$ is selected from the group consisting of ethyl lactate, anisole, tetrahydrofurfuryl alcohol and butyl acetate.

3. Composition according to either of Claims 1 and 2, **characterized in that** the at least one indium alkoxide is an indium(III) alkoxide having at least one C1- to C15-alkoxy or -oxyalkylalkoxy group.

4. Composition according to Claim 3, **characterized in that** the indium(III) alkoxide is indium isopropoxide.

5. Composition according to any one of the preceding claims, **characterized in that** the indium alkoxide is present in the composition in proportions of 1 to 15% by weight, more preferably 2 to 10% by weight, most preferably 2.5 to 7.5% by weight, based on the total mass of the composition.

6. Composition according to any one of the preceding claims, **characterized in that** the boiling point of $L_2$ under SATP conditions is 30 - 120°C and the boiling point of $L_3$ under SATP conditions is 120 - 300°C.

7. Composition according to any one of the preceding claims, **characterized in that** $L_2$ is selected from the group consisting of isopropanol, methanol, ethanol, acetone, toluene, tetrahydrofuran, ethyl acetate, methyl ethyl ketone, chloroform and ethylene glycol dimethyl ether.

8. Composition according to any one of the preceding claims, **characterized in that** $L_3$ is selected from the group consisting of tetrahydrofurfuryl alcohol, butyl acetate, diethylene glycol, anisole, ethylene glycol diacetate, ethyl benzoate and ethyl lactate.

9. Composition according to any one of the preceding claims, **characterized in that** the composition comprises the two solvents isopropanol and diethylene glycol.

10. Composition according to any one of the preceding claims, **characterized in that** the proportion of $L_2$ is 30 - 95% by weight, based on the total mass of the composition, and the proportion of $L_3$ is 0.5 - 70% by weight, based on the total mass of the composition.

11. Composition according to any one of the preceding claims, **characterized in that** the composition comprises at least the three solvents isopropanol, butyl acetate and ethyl lactate.

12. Composition according to any one of the preceding claims, **characterized in that** it also comprises at least one further metal alkoxide.

13. Composition according to Claim 12, **characterized in that** the proportion of the at least one metal alkoxide is 0.01 - 7.5% by weight, based on the total mass of the composition.

14. A process for preparing a liquid indium alkoxide-containing composition according to any one of the preceding claims, **characterized in that** the at least one indium alkoxide is mixed with a mixture of the at least three solvents.

15. A process for preparing a liquid indium alkoxide-containing composition according to any one of Claims 1 to 13, **characterized in that** a composition comprising the at least one indium alkoxide and at least one solvent is mixed with the other solvent(s).

16. The use of a composition according to any one of Claims 1 to 13 for producing semiconductive structures.

17. The use of a composition according to any one of Claims 1 to 13 for producing electronic components, especially for producing (thin-film) transistors, diodes or solar cells.

**Revendications**

1. Composition liquide contenant un alcoxyde d'indium, comprenant :

   - au moins un alcoxyde d'indium et
   - au moins trois solvants $L_1$, $L_2$ et $L_3$,

   **caractérisée en ce que** le solvant $L_1$ est choisi dans le groupe constitué par le lactate d'éthyle, l'anisole, l'alcool tétrahydrofurfurylique, l'acétate de butyle,, le diacétate d'éthylène glycol et le benzoate d'éthyle, et la différence entre les points d'ébullition des deux solvants $L_2$ et $L_3$ en conditions CATP est d'au moins 30 °C, les solvants $L_2$ et $L_3$ étant des solvants organiques, qui sont choisis indépendamment l'un de l'autre dans le groupe constitué par les alcools, les polyalcools, les esters, les amines, les cétones ou les aldéhydes, au moins trois solvants différents étant toujours présents.

2. Composition selon la revendication 1, **caractérisée en ce que** le solvant $L_1$ est choisi dans le groupe constitué par le lactate d'éthyle, l'anisole, l'alcool tétrahydrofurfurylique et l'acétate de butyle.

3. Composition selon la revendication 1 ou 2, **caractérisée en ce que** ledit au moins un alcoxyde d'indium est un alcoxyde d'indium (III) contenant au moins un groupe alcoxy ou oxyalkylalcoxy en C1 à C15.

4. Composition selon la revendication 3, **caractérisée en ce que** l'alcoxyde d'indium (III) est l'isopropoxyde d'indium.

5. Composition selon l'une quelconque des revendications précédentes, **caractérisée en ce que** l'alcoxyde d'indium est présent dans la composition en proportions de 1 à 15 % en poids, de manière particulièrement préférée de 2 à 10 % en poids, de manière tout particulièrement préférée de 2,5 à 7,5 % en poids, par rapport à la masse totale de la composition.

6. Composition selon l'une quelconque des revendications précédentes, **caractérisée en ce que** le point d'ébullition de $L_2$ en conditions CATP est de 30 à 120 °C et le point d'ébullition de $L_3$ en conditions CATP est de 120 à 300 °C.

7. Composition selon l'une quelconque des revendications précédentes, **caractérisée en ce que** $L_2$ est choisi dans le groupe constitué par l'isopropanol, le méthanol, l'éthanol, l'acétone, le toluène, le tétrahydrofurane, l'acétate d'éthyle, la méthyléthylcétone, le chloroforme et l'éther diméthylique d'éthylène glycol.

8. Composition selon l'une quelconque des revendications précédentes, **caractérisée en ce que** $L_3$ est choisi dans le groupe constitué par l'alcool tétrahydrofurfurylique, l'acétate de butyle, le diéthylène glycol, l'anisole, le diacétate d'éthylène glycol, le benzoate d'éthyle et le lactate d'éthyle.

9. Composition selon l'une quelconque des revendications précédentes, **caractérisée en ce que** la composition comprend les deux solvants isopropanol et diéthylène glycol.

10. Composition selon l'une quelconque des revendications précédentes, **caractérisée en ce que** la proportion de $L_2$ est de 30 à 95 % en poids, par rapport à la masse totale de la composition, et la proportion de $L_3$ est de 0,5 à 70 % en poids, par rapport à la masse totale de la composition.

11. Composition selon l'une quelconque des revendications précédentes, **caractérisée en ce que** la composition comprend au moins les trois solvants isopropanol, acétate de butyle et lactate d'éthyle.

12. Composition selon l'une quelconque des revendications précédentes, **caractérisée en ce qu'**elle comprend encore au moins un alcoxyde de métal supplémentaire.

13. Composition selon la revendication 12, **caractérisée en ce que** la proportion dudit au moins un alcoxyde de métal est de 0,01 à 7,5 % en poids, par rapport à la masse totale de la composition.

14. Procédé de fabrication d'une composition liquide contenant un alcoxyde d'indium selon l'une quelconque des revendications précédentes, **caractérisé en ce que** ledit au moins un alcoxyde d'indium est mélangé avec un mélange desdits au moins trois solvants.

15. Procédé de fabrication d'une composition liquide contenant un alcoxyde d'indium selon l'une quelconque des revendications 1 à 13, **caractérisé en ce qu'**une composition comprenant ledit au moins un alcoxyde d'indium et au moins un solvant est mélangée avec le ou les autres solvants.

16. Utilisation d'une composition selon l'une quelconque des revendications 1 à 13 pour la fabrication de structures semi-conductrices.

17. Utilisation d'une composition selon l'une quelconque des revendications 1 à 13 pour la fabrication de composants électroniques, notamment pour la fabrication de transistors (à couche mince), de diodes ou de cellules solaires.

Abbildung 1:

Abbildung 2:

10µm    10000x    FEB 16 2009 13:27
24.1 µm    F78_GR_T350

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 11106934 A
- JP 6136162 A
- JP 9157855 A
- CN 1280960 A
- JP 11106935 A
- JP 2007042689 A

**In der Beschreibung aufgeführte Nicht-Patentliteratur**

- **H.S. KIM ; P.D. BYRNE ; A. FACCHETTI ; T.J. MARKS.** *J. Am. Chem. Soc.,* 2008, vol. 130, 12580-12581
- **H. NAKAZAWA ; Y. ITO ; E. MATSUMOTO ; K. ADACHI ; N. AOKI ; Y. OCHIAI.** *J. Appl. Phys.,* 2006, vol. 100, 093706
- **A. GUPTA ; H. CAO ; PAREKH, K.K.V. RAO ; A.R. RAJU ; U.V. WAGHMARE.** *J. Appl. Phys.,* 2007, vol. 101, 09N513
- **S. CHATTERJEE ; S. R. BINDAL ; R.C. MEHROTRA.** *J. Indian Chem. Soc.,* 1976, vol. 53, 867
- **D.C. BRADLEY ; H. CHUDZYNSKA ; D.M. FRIGO ; M.E. HAMMOND ; M.B. HURSTHOUSE ; M.A. MAZID.** *Polyhedron,* 1990, vol. 9, 719
- **S. SUH ; D. M. HOFFMAN.** *J. Am. Chem. Soc.,* 2000, vol. 122, 9396-9404